(19) Europäisches Patentamt / European Patent Office / Office européen des brevets

(11) **EP 2 676 771 A1**

(12) # EUROPEAN PATENT APPLICATION
published in accordance with Art. 153(4) EPC

(43) Date of publication:
**25.12.2013 Bulletin 2013/52**

(21) Application number: **12747173.8**

(22) Date of filing: **08.02.2012**

(51) Int Cl.:
*B24B 37/26* *(2012.01)*    *B24B 37/22* *(2012.01)*
*H01L 21/304* *(2006.01)*

(86) International application number:
**PCT/JP2012/052843**

(87) International publication number:
**WO 2012/111502 (23.08.2012 Gazette 2012/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.02.2011 JP 2011029393**

(71) Applicant: **Toray Industries, Inc.**
**Tokyo 103-8666 (JP)**

(72) Inventors:
• **TAKEUCHI, Nana**
  **Shiga 520-8558 (JP)**
• **FUKUDA, Seiji**
  **Shiga 520-8558 (JP)**
• **OKUDA, Ryoji**
  **Shiga 520-8558 (JP)**
• **KASAI, Shigetaka**
  **Chiba 279-8555 (JP)**

(74) Representative: **Webster, Jeremy Mark et al**
**Mewburn Ellis LLP**
**33 Gutter Lane**
**London**
**EC2V 8AS (GB)**

(54) **POLISHING PAD**

(57)     A polishing pad comprising at least a polishing layer and a cushion layer, wherein a groove is formed on a polishing surface of the polishing pad, at least one of angles formed by the polishing surface and a side surface of the groove which continues to the polishing surface is 105-150° inclusive, and the cushion layer has a strain constant of $7.3\times10^{-6}$ to $4.4\times10^{-4}$ µm/Pa inclusive. The use of the polishing pad can achieve a purpose of preventing the fluctuation in a polishing rate while keeping the polishing rate at a high level.

[Fig. 2]

**Description**

TECHNICAL FIELD

The present invention relates to a polishing pad. More particularly, the present invention relates to a polishing pad which is preferably used for forming a flat surface in a semiconductor, a dielectric-metal composite and an integrated circuit.

BACKGROUND ART

With increases in the density of semiconductor device, technologies of multilayer wiring and the formation of an interlayer insulation film associated therewith or the formation of electrodes such as plug or damascene become more important. In association with this, the importance of a process of planarizing these interlayer insulation films and metal layers of electrodes increases, and as an efficient technology for the planarization process, a polishing technology referred to as CMP (Chemical Mechanical Polishing) has been widespread.

In general, a chemical mechanical polishing apparatus is composed of a polishing head for holding a semiconductor wafer of a material to be processed, a polishing pad for carrying out polishing of the material to be processed, and a polishing platen holding the polishing pad. The polishing of the semiconductor wafer is a process of using a slurry, and causing relative movement between the semiconductor wafer and the polishing pad to remove a projected portion on the surface layer of the semiconductor wafer to planarize the surface layer of the wafer.

In polishing characteristics of CMP, there are various required characteristics typified by securement of local flatness and global flatness of a wafer, prevention of scratches, or securement of a high polishing rate. Hence, in order to achieve these characteristics, various contrivances were made concerning a configuration of a groove (a pattern of a groove and a cross-sectional shape of a groove) of the polishing pad, which is one of large factors among factors affecting polishing characteristics.

For example, a pattern of the groove formed on the polishing layer surface is concentric, and by employing an approximately rectangular shape as a cross-sectional shape of the groove, the flatness of a wafer or the polishing rate is improved (for example, Patent Document 1).

However, a corner portion in a cross-sectional shape of the groove, or burrs formed at the corner portion resulting from dressing performed before or after polishing or during polishing may cause scratches on the surface of the wafer. It is described to dispose an inclined surface at a boundary part between the polishing surface and the groove in order to solve this problem (for example, Patent Documents 2, 3).

PRIOR ART DOCUMENTS

PATENT DOCUMENTS

Patent Document 1: Japanese Patent Laid-open Publication No. 2002-144219
Patent Document 2: Japanese Patent Laid-open Publication No. 2004-186392
Patent Document 3: Japanese Patent Laid-open Publication No. 2010-45306

SUMMARY OF THE INVENTION

PROBLEMS TO BE SOLVED BY THE INVENTION

Here, the present inventors found that by providing an inclined surface at a boundary portion between the polishing surface and the groove, not only the scratches are decreased, but also an attractive force works between the wafer and the polishing pad to increase the polishing rate at a specific inclination angle. However, we also found that this may cause an increase in the fluctuation in a polishing rate too.

In view of such problems of the prior art, it is an object of the present invention to provide a polishing pad which can particularly suppress the fluctuation in a polishing rate while maintaining a high polishing rate among polishing characteristics.

SOLUTIONS TO THE PROBLEMS

The present inventors thought that an irregular attractive force causes the fluctuation in a polishing rate, and it can be solved by combining a cushion layer with a substance having rigidity.

Hence, the present invention employs the following means in order to solve the above-mentioned problems. That is, the present invention pertains to a polishing pad comprising at least a polishing layer and a cushion layer, wherein a groove is formed on a polishing surface of the polishing pad, angles formed by the polishing surface and a side surface of the groove which continues to the polishing surface is 105° or more and 150° or less, and the cushion layer has a strain constant of at least $7.3 \times 10^{-6}$ $\mu$m/Pa and at most $4.4 \times 10^{-4}$ $\mu$m/Pa.

EFFECTS OF THE INVENTION

In accordance with the present invention, it is possible to provide a polishing pad which can suppress the fluctuation in a polishing rate while maintaining a high polishing rate.

BRIEF DESCRIPTION OF THE DRAWINGS

Fig. 1 shows an example of a top surface configuration of a groove formed on a polishing pad of the present invention.
Fig. 2 shows an example of a cross-sectional surface configuration of the groove formed on the polishing pad of the present invention.
Fig. 3 shows an example of a cross-sectional surface configuration of the groove formed on the polishing pad of the present invention.
Fig. 4 shows an example of a cross-sectional surface configuration of the groove formed on the polishing pad of the present invention.
Fig. 5 shows an example of a cross-sectional surface configuration of the groove formed on the polishing pad of the present invention.
Fig. 6 shows an example of a cross-sectional surface configuration of the groove formed on the polishing pad of the present invention.

EMBODIMENTS OF THE INVENTION

The present invention is completed by finding out, as a result of the earnest investigations concerning a polishing pad capable of suppressing the fluctuation in a polishing rate while maintaining a high polishing rate, that the problem can be solved at once by a polishing pad comprising at least a polishing layer and a cushion layer, wherein a groove is formed on a polishing surface of the polishing pad, angles formed by the  polishing surface and a side surface of the groove which continues to the polishing surface is 105° or more and 150° or less, and the cushion layer has a strain constant of at least $7.3 \times 10^{-6}$ $\mu$m/Pa and at most $4.4 \times 10^{-4}$ $\mu$m/Pa.

In the present invention, it is important that the polishing pad has at least a polishing layer and a cushion layer. When the polishing pad does not have the cushion layer, since strain due to water absorption of the polishing layer cannot be cushioned, a polishing rate and in-plane uniformity of a material to be polished are fluctuated unstably. In the present invention, the strain constant of the cushion layer is in the range of at least $7.3 \times 10^{-6}$ $\mu$m/Pa and at most $4.4 \times 10^{-4}$ $\mu$m/Pa. When the strain constant of the cushion layer falls within this range, the fluctuation in a polishing rate can be significantly suppressed while maintaining the effect of improving a polishing rate by the groove having an inclination. From the viewpoint of the fluctuation in a polishing rate and local flatness of the material to be polished, an upper limit of the strain constant is more preferably $3.0 \times 10^{-4}$ $\mu$m/Pa or less, and moreover preferably $1.5 \times 10^{-4}$ $\mu$m/Pa or less. A lower limit of the strain constant is more preferably $1.0 \times 10^{-5}$ $\mu$m/Pa or more, and moreover preferably $1.2 \times 10^{-5}$ $\mu$m/Pa or more. When  the fluctuation in a polishing rate is large, a polished amount of the material to be polished is fluctuated, and consequently a thickness of a remaining layer of the material to be polished is fluctuated to adversely affect semiconductor device performance. Accordingly, the fluctuation in a polishing rate is preferably 40.0 nm/min or less, and more preferably 20.0 nm/min or less.

In addition, the strain constant in the present invention was determined by a method in which using an indenter having a tip of 5 mm in diameter, a thickness at the time of applying a pressure of 27 kPa for 60 seconds with a dial gage is taken as (T1) $\mu$m, and subsequently a thickness at the time of applying a pressure of 177 kPa for 60 seconds is taken as (T2) $\mu$m, and the strain constant is calculated according to the following equation:

```
Strain constant (μm/Pa) = (T1 - T2)/(177 - 27)/1000.
```

Examples of materials of such the cushion layer include nonfoamed elastomers such as natural rubbers, nitrile rubbers, "neoprene (registered trademark) " rubbers, polybutadiene rubbers, thermosetting polyurethane rubbers, thermoplastic polyurethane rubbers, silicone rubbers and "Hytrel (registered trademark)"; polyolefin foams such as "TORAYPEF (registered trademark, PEF produced by Toray Industries, Inc.)"; and nonwoven fabrics such as "suba 400" produced by Nitta Haas Incorporated, but the material is not limited to these materials.

The strain constant of the cushion layer can be adjusted according to a material of the cushion layer. For example, when the cushion layer is a foamed body, if a degree of foaming is increased, the strain constant tends to increase because of tendency to be soft. Further, when the cushion layer is nonfoamed, it is possible to adjust hardness by adjusting a degree of crosslinking within the cushion layer.

A thickness of the cushion layer is preferably in a range of 0.1 to 2 mm. The thickness is preferably 0.25 mm or more, and more preferably 0.3 mm or more from the viewpoint of in-plane uniformity of the entire surface of a semiconductor substrate. The thickness is preferably 2 mm or less, and more preferably 1 mm or less from the viewpoint of local flatness.

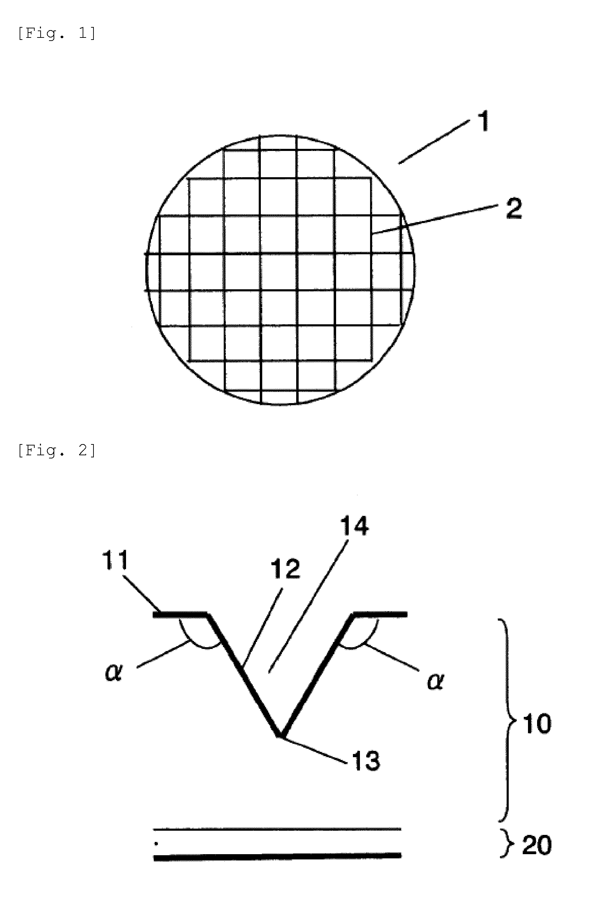

The surface of the polishing layer of the polishing pad in the present invention has grooves. The configuration of the groove viewed from the surface of the polishing layer includes grid-like, concentric circle-like, spiral, and radial grooves, but the configuration is not limited to these. Since the groove of an open system in which the groove extends in a radial direction can renew the slurry more effectively, a radial groove or a grid-like groove is the most preferable. An example of the grid-like groove is shown in Fig. 1. The grid-like groove 2 is formed on a polishing pad 1. The pitch or the width of the groove is not particularly limited, and the shape of a section divided by the grid-like groove may be square or rectangular.

Further, at least one of angles (hereinafter, sometimes referred to as "an inclination angle") formed by the polishing surface and a side surface of the groove which continues to the polishing surface is 105° or more and 150° or less, and thereby, it is possible to suppress the fluctuation in a polishing rate while maintaining a high polishing rate. A lower limit of the angle is preferably 115° or more from the viewpoint of the retention and fluidity of the slurry. Further, an upper limit of the angle is preferably 140° or less, more preferably 135° or less, and particularly preferably 130° or less. Since the slurry can be substantially supplied stably to the inclined surface by improving the retention and fluidity of the slurry, the fluctuation in a polishing rate can be suppressed. Since the slurry is flown by a centrifugal force, it is more effective that the inclination is provided at a side surface located at least on a circumference side of opposed side surfaces which form the groove. When one of the inclination angles of the groove is in the above range, the other inclination angle is also not particularly limited, but, similarly, is preferably 105° or more and 150° or less. At this time, the lower limit of the angle is more preferably 115° or more. The upper limit of the angle is more preferably 140° or less, moreover preferably 135° or less, and particularly preferably 130° or less. A groove configuration in which both inclination angles are approximately the same is a more preferable aspect. However, both inclination angles do not have to be approximately the same. A shape of a groove bottom is not particularly limited, and a cross-sectional shape may be V-shaped, U-shaped or trapezoidal.

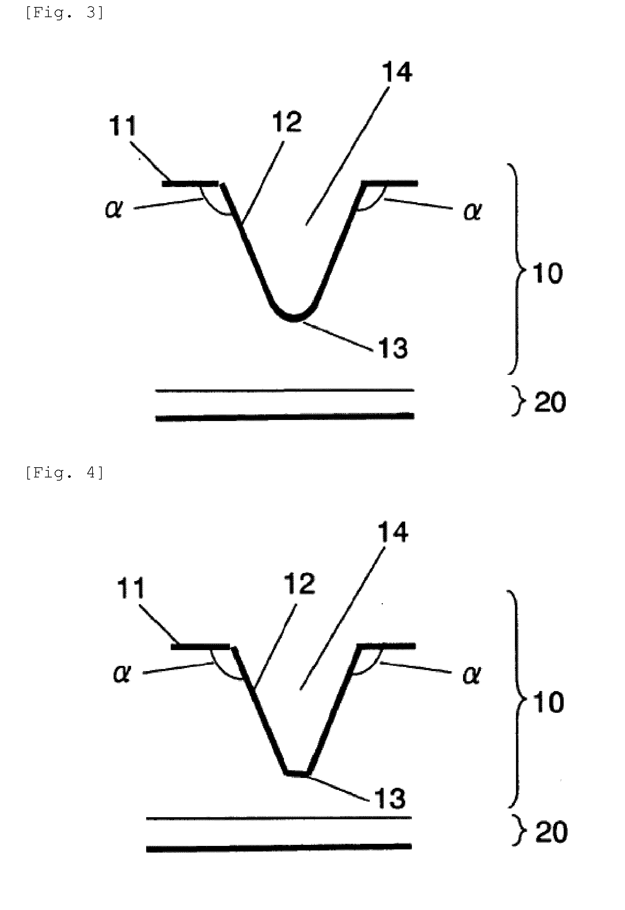

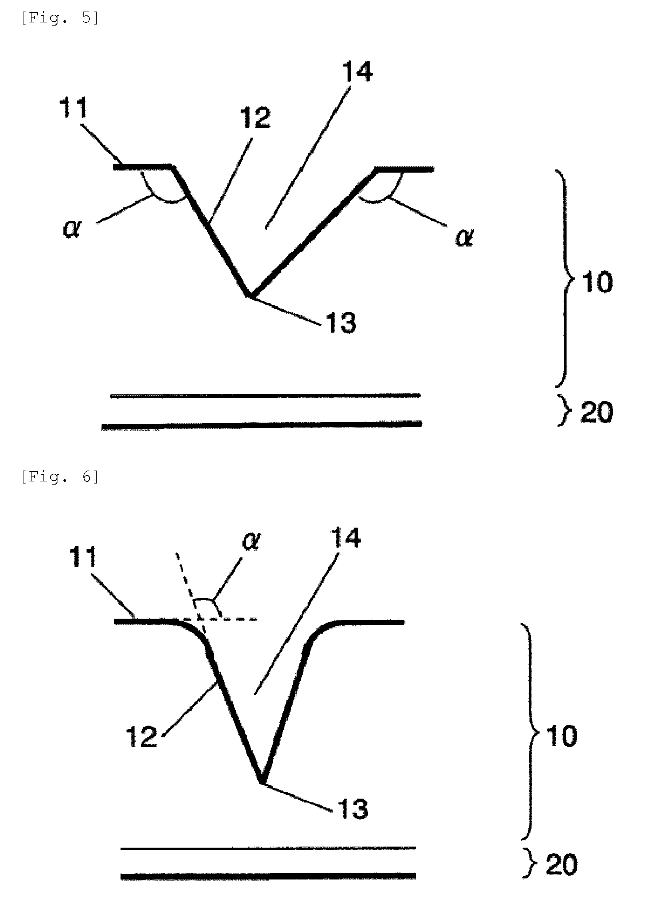

A specific configuration of the groove in the present invention described above will be described by way of drawings. Fig. 2 to Fig. 6 are partial sectional views obtained by enlarging a groove 14 portion of a polishing pad having a polishing layer 10 on a cushion layer 20. The polishing layer 10 has a polishing surface 11 and a side surface 12 which continues to the polishing surface 11. The angle $\alpha$ is the above-mentioned inclination angles, and at least one of the angles is 105° or more and 150° or less. A shape (cross-sectional shape) of a groove bottom 13 is V-shaped in Fig. 2, U-shaped in Fig. 3, and trapezoidal in Fig. 4, but the shape is not limited to these shapes as described above. Further, in Fig. 2 to Fig. 4, inclination angles $\alpha$ on both sides are approximately the same, and this is a more preferable embodiment, but the present invention is not limited to this embodiment. For example, in Fig. 5, the inclination angles $\alpha$ on both sides are different, and any embodiment may be employed. In addition, as shown in Fig. 6, when a boundary between the polishing surface and the side surface of the groove which continues to the polishing surface is in the form of a curved line, the respective surfaces are linearly extended, and the angle of intersection at the intersection of the two extended straight lines is taken as an inclination angle.

As the polishing layer composing the polishing pad, a polishing layer having a structure including independent air bubbles is preferred since the polishing layer forms a flat surface in a semiconductor, a dielectric-metal composite and an integrated circuit. The hardness of the polishing layer is preferably 45 to 65 degrees in terms of measurement by an ASKER D hardness tester. When the ASKER D hardness is less than 45 degrees, planarity of the material to be polished is deteriorated, and when the ASKER D hardness is more than 65 degrees, the planarity is good, but uniformity of the material to be polished tends to decrease.

The material forming the polishing layer having the above-mentioned structure is not particularly limited, and examples thereof include polyethylene, polypropylene, polyester, polyurethane, polyurea, polyamide, polyvinyl chloride, polyacetal, polycarbonate, polymethyl methacrylate, polytetrafluoroethylene, epoxy resins, ABS resin, AS resins, phenol resins, melamine resins, "neoprene (registered trademark)" rubbers, butadiene rubbers, styrene-butadiene rubbers, ethylene-propylene rubbers, silicone rubbers, fluorine-containing rubbers and resins predominantly composed of these materials. These materials may be used in combination of two or more thereof. In these resins, a material predominantly composed of polyurethane is more preferred in that a diameter of an independent air bubble can be relatively easily controlled.

The polyurethane is a polymer synthesized by a polyaddition reaction or a polymerization reaction of polyisocyanate. A compound used as a reference of polyisocyanate is a compound containing activated hydrogen, that is, a compound containing two or more polyhydroxy groups or amino groups. Examples of the polyisocyanate include, but not limited to, tolylene diisocyanate, diphenylmethane diisocyanate, naphthalene diisocyanate, hexamethylene diisocyanate, and isophorone diisocyanate. These compounds may be used in combination of two or more thereof.

As the compound containing polyhydroxy groups, polyols are typical, and examples thereof include polyether polyol, polyteramethylene ether glycol, epoxy resin-modified polyol, polyester polyol, acrylic polyol, polybutadiene polyol, and silicone polyol. These polyols may be used in combination of two or more thereof. It is preferred to determine a combination of polyisocyanate and polyol, and a combination or an optimum amount of these compounds, a catalyst, a foaming agent and a foam stabilizer according to the hardness, the bubble diameter and the expansion ratio.

As a method of forming independent air bubbles in these polyurethanes, a chemical foaming process in which various foaming agents are mixed in a resin at the time of producing polyurethane is common, but a method of foaming a resin by mechanical stirring and then curing the resin can also be preferably used.

An average bubble diameter of the independent air bubbles is preferably 30 $\mu$m or more from the viewpoint of reducing scratches. On the other hand, the average bubble diameter of the independent air bubbles is preferably 150 $\mu$m or less, more preferably 140 $\mu$m or less, and moreover preferably 130 $\mu$m or less from the viewpoint of the flatness of local projection and depression of the material to be polished. In addition, the average bubble diameter can be obtained by observing a sample cross-section at a magnification of 400 times with an ultra-deep shape measuring microscope VK-8500 manufactured by KEYENCE Corporation, selecting images of circle bubbles excluding bubbles which are positioned at an end of a field of view and lacks partially among bubbles observed in one field of view, and processing the selected images of circle bubbles with an image processing apparatus to determine circle equivalent diameters from the cross-sectional areas of the bubbles to calculate a number average value.

A preferable embodiment of the polishing pad in the present invention is a pad containing a polymer of a vinyl compound and polyurethane and having independent air bubbles. The polymer of a vinyl compound alone can enhance the toughness and the hardness of the pad, but hardly attain a homogeneous polishing pad having independent air bubbles, and polyurethane becomes brittle when the hardness is increased. By impregnating polyurethane with a vinyl compound, a polishing pad including independent air bubbles and having high toughness and high hardness can be formed.

The vinyl compound is a compound having a polymerizable carbon-carbon double bond. Specific examples of the vinyl compound include methyl acrylate, methyl methacrylate, ethyl acrylate, ethyl methacrylate, n-butyl acrylate, n-butyl methacrylate, 2-ethylhexyl methacrylate, isodecyl methacrylate, n-lauryl methacrylate, 2-hydroxyethyl methacrylate, 2-hydroxypropyl methacrylate, 2-hydroxybutyl methacrylate, dimethylaminoethyl methacrylate, diethylaminoethyl methacrylate, glycidyl methacrylate, ethylene glycol dimethacrylate, acrylic acid, methacrylic acid, fumaric acid, dimethyl fumarate, diethyl fumarate, dipropyl fumarate, maleic acid, dimethyl maleate, diethyl maleate, dipropyl maleate, phenyl maleimide, cyclohexyl maleimide, isopropyl maleimide, acrylonitrile, acrylamide, vinyl chloride, vinylidene chloride, styrene, $\alpha$-methyl styrene, divinyl benzene, ethylene glycol dimethacrylate, diethylene glycol dimethacrylate and the like. These vinyl compounds may be used in combination of two or more thereof.

Among the above-mentioned vinyl compounds, $CH_2=CR^1COOR^2$ ($R^1$: methyl group or ethyl group, $R^2$: methyl group, ethyl group, propyl group or butyl group) is preferred. Among these, methyl methacrylate, ethyl methacrylate, n-butyl methacrylate and isobutyl methacrylate are preferred in that the formation of independent air bubbles in polyurethane is easy, the ability to be impregnated with a monomer is good, polymerization/curing is easy, and the hardness of a polymer of a vinyl compound polymerized/cured and a foam structure containing polyurethane is high and planarization characteristics are good.

Examples of polymerization initiators to be preferably used for obtaining these polymers of a vinyl compound include radical initiators such as azobisisobutyronitrile, azobis(2,4-dimethylvaleronitrile), azobiscyclohexanecarbonitrile, benzoylperoxide, lauroyl peroxide, and isopropylperoxy dicarbonate. These initiators may be used in combination of two or more thereof. Further, an oxidation-reduction based polymerization initiator, for example, a combination of peroxide and amines can also be used.

Examples of a method of impregnating polyurethane with the vinyl compound include a method of immersing polyurethane in a container containing a vinyl compound. In addition, in such a case, it is also preferred to perform a treatment such as heating, pressurizing, depressurizing, stirring, shaking, and ultrasonic vibration for the purpose of increasing an impregnating speed.

An amount of the vinyl compound with which polyurethane is impregnated has to be decided depending on the type of the vinyl compound and polyurethane resin to be used or the characteristics of the polishing pad to be manufactured, and the content ratio of the polymer obtained from a vinyl compound and polyurethane in a foamed structure polymerized/cured is preferably 30/70 to 80/20 by weight, although one cannot speak generally, When the content ratio of the polymer obtained from a vinyl compound is 30/70 or more, the hardness of the polishing pad can be adequately high. When the content ratio is less than 80/20, the elasticity of the polishing layer can be adequately high.

In addition, the contents of the polymer obtained from a vinyl compound polymerized/cured in polyurethane and polyurethane can be measured by a technique of pyrolysis gas chromatography/pyrolysis mass spectrometry. An apparatus which can be used in this technique includes a double shot pyrolyzer ""PY-2010D" (manufactured by Frontier Laboratories Ltd.) as a pyrolysis apparatus, and includes "TRIO-1" (manufactured by VG SCIENTA Co., Ltd.) as a gas chromatograph/mass spectrometer.

In the present invention, it is preferred that a phase of the polymer obtained from a vinyl compound is not separated from a phase of polyurethane, and contained in a phase of polyurethane from the viewpoint of the flatness of local projection and depression of the semiconductor substrate. Quantitatively describing, the spectra obtained by observing the polishing pad with a micro-infrared spectroscope with a spot size of 50 $\mu$m has an infrared absorption peak of the polymer polymerized from a vinyl compound and an infrared absorption peak of polyurethane, and infrared spectra of various locations are substantially the same. The micro-infrared spectroscope used herein includes IR$\mu$s manufactured by SPECTRA-TECH Inc.

The polishing pad may contain various types of additives such as a polishing agent, an antistatic agent, a lubricant, a stabilizer and a dye for the purpose of improving characteristics.

In the present invention, the density of the polishing layer is preferably 0.3 g/cm$^3$ or more, more preferably 0.6 g/cm$^3$ or more, and moreover preferably 0.65 g/cm$^3$ or more from the viewpoint of reducing defective local flatness or global difference in height. On the other hand, from the viewpoint of reducing scratches, the density of the polishing layer is preferably 1.1 g/cm$^3$ or less, more preferably 0.9 g/cm$^3$ or less, and moreover preferably 0.85 g/cm$^3$ or less. In addition, the density of the polishing layer in the present invention was measured by using a Harvard type picnometer (JIS R-3503) and using water as a medium.

Examples of the material to be polished in the present invention include an insulating layer formed on the semiconductor wafer or the surface of a metal-wiring. Examples of the insulating layer include an interlayer insulation film of the metal-wiring, a lower insulating layer of the metal-wiring, and a shallow trench isolation to be used for isolating elements. Examples of a material of the metal-wiring include aluminum, tungsten, copper and alloys thereof, and a structure of the metal-wiring includes damascene, dual damascene and plug. When copper is used as the metal-wiring, a barrier metal such as silicon nitride is also an object of polishing. The main stream of the insulating layer is currently silicon oxide, and a low dielectric insulating layer is also used. The polishing pad of the present invention can also be used for polishing a magnetic head, a hard disc, sapphire, SiC, and MEMS (micro electro mechanical system) other than the semiconductor wafer.

The polishing method of the present invention is suitably used for forming a flat surface on the glass, the semiconductor, the dielectric/metal composite, and the integrated circuit.

EXAMPLES

Hereinafter, the present invention will be described in more detail by way of examples. However, the present examples are not to be construed to limit the invention. In addition, measurement was performed as follows.

<Measurement of Bubble Diameter>

As the average bubble diameter, a number average value was used, which was obtained by observing a sample cross-section at a magnification of 400 times with an ultra-deep shape measuring microscope VK-8500 manufactured by KEYENCE Corporation, selecting images of circle bubbles excluding bubbles which were positioned at an end of a field of view and lacked partially among bubbles observed in one field of view, and processing the selected images of circle bubbles with an image processing apparatus to determine circle equivalent diameters from the cross-sectional areas of the bubbles to calculate an average value.

<Measurement of Hardness>

Hardness was measured according to JIS K 6253 (1997). The prepared polyurethane resin was cut out into a size of 2 cm × 2 cm (thickness: arbitrary) and left standing for 16 hours as a sample for hardness measurement under environments of temperature of 23°C ± 2°C and humidity of 50% ± 5%. When being measured, the samples were overlaid to keep a thickness of 6 mm or more. The hardness was measured by use of a hardness tester (manufactured by KOBUNSHI KEIKI CO., LTD., ASKER D type hardness tester).

<Measurement of Microrubber A Hardness>

The cushion layer was cut out into a size of 3 cm $\times$ 3 cm and left standing for 16 hours as a sample for hardness measurement under environments of temperature of 23°C $\pm$ 2°C and humidity of 50% $\pm$ 5%. Microrubber A hardness was measured at different three points in a sample by use of a microrubber hardness tester MD-1 manufactured by KOBUNSHI KEIKI CO., LTD., and a calculated average value was taken as a microrubber A hardness.

<Measurement of Inclination Angle>

A pad in which grooves were formed on the polishing layer surface was placed so that a razor's blade was arranged to be perpendicular to a direction of the groove, and sliced in a direction of a groove depth, and a cross-section of the groove was observed with an ultra-deep shape measuring microscope VK-8500 manufactured by KEYENCE Corporation to measure an angle formed by the polishing surface and the side surface of the groove which continues to the polishing surface. Two grooves which were the closest to the position distance of a third of radius and the position distance of two-thirds of radius from a center of the pad were measured, and an average of these two grooves was taken as an inclination angle.

<Determination of Strain Constant>

Using an indenter having a tip of 5 mm in diameter, a thickness at the time of applying a pressure of 27 kPa for 60 seconds with a dial gauge was taken as (T1) $\mu$m, and subsequently a thickness at the time of applying a pressure of 177 kPa for 60 seconds was taken as (T2) $\mu$m, and the strain constant was calculated according to the following equation:

$$\text{Strain constant } (\mu\text{m/Pa}) = (\text{T1} - \text{T2})/(177 - 27)/1000.$$

<Average Polishing Rate>

Using MIRRA 3400 manufactured by Applied Materials, Inc., polishing was carried out under predetermined polishing conditions while detecting an end point. Polishing characteristics were measured in a direction of a diameter excluding an outermost 1 mm-circumference of an 8-inch wafer. Polishing characteristics were measured at 37 points which were located for every 5 mm within a radius of 90 mm from a center in the plane and 18 points which were located for every 1 mm outside a radius of 91 mm from a center in the plane to determine an average polishing rate (nm/min).

<Determination of Fluctuation in Polishing Rate>

Five hundred of wafers were polished, an average polishing rate of each wafer was measured, and the fluctuation in a polishing rate was calculated according to the following equation:
Fluctuation in polishing rate (n, /min) = (Maximum average polishing rate of wafer) - (Minimum average polishing rate of wafer).

Example 1

In a molding machine RIM, 30 parts by weight of polypropylene glycol, 40 parts by weight of diphenylmethane diisocyanate, 0.5 part by weight of water, 0.3 part by weight of triethylamine, 1.7 parts by weight of a silicone foam stabilizer, and 0.09 part by weight of tin octylate were mixed, and the resulting mixture was discharged to a die and molded by pressure molding to prepare a foamed polyurethane sheet including independent air bubbles.
The foamed polyurethane sheet was immersed for 60 minutes in methyl methacrylate containing 0.2 part by weight of azobisisobutyronitrile. Then, the foamed polyurethane sheet was immersed in a solution composed of 15 parts by weight of polyvinyl alcohol "CP" (polymerization degree: about 500, produced by NACALAI TESQUE, INC.), 35 parts by weight of ethyl alcohol (reagent special grade, produced by KATAYAMA CHEMICAL INDUSTRIES Co., Ltd.) and 50 parts by weight of water, and dried to coat the surface layer of the foamed polyurethane sheet with polyvinyl alcohol.
Next, the foamed polyurethane sheet was sandwiched between two glass sheets with a vinyl chloride gasket interposed between the sheet and the glass sheet and heated at 65°C for 6 hours and at 120°C for 3 hours, and thereby, the sheet was polymerized/cured. The polymerized sheet was released from between glass sheets and washed with water, and then vacuum-dried at 50°C. A hard foamed sheet thus obtained was sliced into a thickness of 2.00 mm, and both surfaces were ground to prepare a polishing layer. The content of methyl methacrylate in the polishing layer was 66% by weight. The polishing layer had the D hardness of 54 degrees and the density of 0.81 g/cm$^3$, and an average bubble diameter of the independent air bubbles was 45 $\mu$m.

Thermoplastic polyurethane (cushion layer thickness: 0.3 mm) having a strain constant of 0.15 $\times$ 10$^{-4}$ $\mu$m/Pa (microrubber A hardness 89 degrees) produced by Nihon Matai Co., Ltd. as a cushion layer was laminated on the polishing layer obtained by the above method with an adhesive layer MA-6203 produced by Mitsui Chemicals Polyurethanes, Inc. therebetween by using a roll coater, and further a double-faced tape 5604 TDM manufactured by SEKISUI CHEMICAL CO., LTD. was bonded to a backside as a backside tape. This laminate was punched out into a circle with a diameter of 508 mm, and grooves having an inclination angle of 123 degrees and a depth of 1.5 mm were formed on the surface of the polishing layer at a groove pitch of 15 mm in the form of XY lattice to prepare a polishing pad.

The polishing pad obtained by the above method was attached to a platen of a polishing machine ("MIRRA 3400" manufactured by Applied Materials, Inc.). Five-hundred pieces of 8-inch wafers of oxide film were polished under the conditions in which a retainer ring pressure = 41 kPa (6 psi), an inner tube pressure = 28 kPa (4 psi), a membrane pressure = 28 kPa (4 psi), a platen rotational speed = 76 rpm, a polishing head rotational speed = 75 rpm, and a diluted slurry formed by diluting slurry (SS-25 manufactured by Cabot Corporation) with an equal volumetric amount of pure water was flown at a flow rate of 150 ml/min, and in-situ dressing was carried out for 30 seconds after the start of polishing at a load of 17.6 N (4 lbf) and at a polishing time of 1 minute by using a dresser manufactured by Saesol CHEMICAL CO., LTD. The average polishing rate of the five hundredth of the oxide film was 216.6 nm/min. The fluctuation in a polishing rate of 500 oxide films was as good as 10.5 nm/min.

Example 2

A wafer of an oxide film was polished in the same manner as in Example 1 except for changing the inclination angle of the groove on the polishing layer surface to 110°. An average polishing rate was 185.0 nm/min, and the fluctuation in a polishing rate was as good as 25.4 nm/min.

Example 3

A wafer of an oxide film was polished in the same manner as in Example 1 except for changing the inclination angle of the groove on the polishing layer surface to 140°. An average polishing rate was 227.3 nm/min, and the fluctuation in a polishing rate was as good as 23.8 nm/min.

Example 4

A wafer of an oxide film was polished in the same manner as in Example 1 except for changing the cushion layer to a polyolefin foam (TORAYPEF produced by Toray Industries, Inc., expansion ratio 3 times, cushion layer thickness: 1.0 mm) having a strain constant of 2.6 $\times$ 10$^{-4}$ $\mu$m/Pa (microrubber A hardness 65°). An average polishing rate was 193.0 nm/min, and the fluctuation in a polishing rate was as good as 31.0 nm/min.

Example 5

A wafer of an oxide film was polished in the same manner as in Example 1 except for forming twenty of grooves which were arranged radially and equally spaced on the polishing layer surface. An average polishing rate was 191.4 nm/min, and the fluctuation in a polishing rate was as good as 24.3 nm/min.

Example 6

A wafer of an oxide film was polished in the same manner as in Example 1 except for changing the pitch and the inclination angle of the groove on the polishing layer surface to 11.5 mm and 135°, respectively. An average polishing rate was 225.0 nm/min, and the fluctuation in a polishing rate was as good as 12.6 nm/min.

Example 7

A wafer of an oxide film was polished in the same manner as in Example 1 except for changing the inclination angle of the groove on the polishing layer surface to 135°. An average polishing rate was 223.2 nm/min, and the fluctuation in a polishing rate was as good as 18.7 nm/min.

Example 8

A wafer of an oxide film was polished in the same manner as in Example 1 except for changing the cushion layer to a polyolefin foam (TORAYPEF produced by Toray Industries, Inc., expansion ratio 4 times, cushion layer thickness: 1.0 mm) having a strain constant of $3.8 \times 10^{-4}$ $\mu$m/Pa (microrubber A hardness 57°). An average polishing rate was 192.1 nm/min, and the fluctuation in a polishing rate was as good as 36.4 nm/min.

Example 9

A wafer of an oxide film was polished in the same manner as in Example 1 except for changing the inclination angle of the groove on the polishing layer surface to 135° and changing the cushion layer to a polyolefin foam (TORAYPEF produced by Toray Industries, Inc., expansion ratio 3 times, cushion layer thickness: 1.0 mm) having a strain constant of $2.6\ 6 \times 10^{-4}$ $\mu$m/Pa (microrubber A hardness 65°). An average polishing rate was 201.3 nm/min, and the fluctuation in a polishing rate was as good as 33.1 nm/min.

Example 10

A wafer of an oxide film was polished in the same manner as in Example 1 except for changing the inclination angle of the groove on the polishing layer surface to 135° and changing the cushion layer to a polyolefin foam (TORAYPEF produced by Toray Industries, Inc., expansion ratio 4 times, cushion layer thickness: 1.0 mm) having a strain constant of $3.8\ 8 \times 10^{-4}$ $\mu$m/Pa (microrubber A hardness 57°). An average polishing rate was 208.4 nm/min, and the fluctuation in a polishing rate was as good as 38.2 nm/min.

Example 11

A wafer of an oxide film was polished in the same manner as in Example 1 except for changing two inclination angles facing each other across the groove on the polishing layer surface to 135° and 130°, respectively. An average polishing rate was 220.9 nm/min, and the fluctuation in a polishing rate was as good as 19.0 nm/min.

Example 12

A polyester film having a thickness of 188 $\mu$m was bonded to a backside of a polishing layer with an adhesive sandwiched, and a cushion layer was bonded to the polyester film surface. A wafer of an oxide film was polished in the same manner as in Example 1 except for changing the inclination angle of the groove on the polishing layer surface to 135°. An average polishing rate was 233.3 nm/min, and the fluctuation in a polishing rate was as good as 21.8 nm/min.

Comparative Example 1

A wafer of an oxide film was polished in the same manner as in Example 1 except for changing the inclination angle of the groove on the polishing layer surface to 90°. An average polishing rate was 182.1 nm/min, and the fluctuation in a polishing rate was as large as 107.7 nm/min.

Comparative Example 2

A wafer of an oxide film was polished in the same manner as in Example 1 except for changing the cushion layer to suba 400 produced by Nitta Haas Incorporated (cushion layer thickness: 1.25 mm) having a strain constant of $6.5 \times 10^{-4}$ $\mu$m/Pa (microrubber A hardness 51°) and changing the inclination angle of the groove on the polishing layer surface to 135°. An average polishing rate was 234.3 nm/min, and the fluctuation in a polishing rate was as large as 184.7 nm/min.

Comparative Example 3

A wafer of an oxide film was polished in the same manner as in Example 1 except for changing the cushion layer to NIPPARON EXT produced by NHK SPRING CO., LTD. (cushion layer thickness: 0.8 mm) having a strain constant of $5.2 \times 10^{-4}$ $\mu$m/Pa (microrubber A hardness 59°) and changing the inclination angle of the groove on the polishing layer surface to 135°. An average polishing rate was 221.8 nm/min, and the fluctuation in a polishing rate was as large as 165.5 nm/min.

Comparative Example 4

A wafer of an oxide film was polished in the same manner as in Example 1 except for changing the inclination angle of the groove on the polishing layer surface to 155°. An average  polishing rate was 215.5 nm/min, and the fluctuation in a polishing rate was as large as 63.2 nm/min.

Comparative Example 5

A wafer of an oxide film was polished in the same manner as in Example 1 except for changing the cushion layer to suba 400 produced by Nitta Haas Incorporated, (cushion layer thickness: 1.25 mm) having a strain constant of $6.5 \times 10^{-4}$ $\mu$m/Pa (microrubber A hardness 51°). An average polishing rate was 226.1 nm/min, and the fluctuation in a polishing rate was as large as 173.0 nm/min.

The results of Examples and Comparative Examples are summarized in Table 1.

[Table 1]

[Table 1]

|  | Inclination Angle | Strain Constant $\times 10^{-4}$ $\mu$m/Pa | Microrubber A Hardness | Polishing Rate nm/min | Fluctuation in Polishing Rate nm/min |
|---|---|---|---|---|---|
| Example 1 | 123 | 0.15 | 89 | 216.6 | 10.5 |
| Example 2 | 110 | 0.15 | 89 | 185.0 | 25.4 |
| Example 3 | 140 | 0.15 | 89 | 227.3 | 23.8 |
| Example 4 | 123 | 2.6 | 65 | 193.0 | 31.0 |
| Example 5 | 123 | 0.15 | 89 | 191.4 | 24.3 |
| Example 6 | 135 | 0.15 | 89 | 225.0 | 12.6 |
| Example 7 | 135 | 0.15 | 89 | 223.2 | 18.7 |
| Example 8 | 123 | 3.8 | 57 | 192.1 | 36.4 |
| Example 9 | 135 | 2.6 | 65 | 201.3 | 33.1 |
| Example 10 | 135 | 3.8 | 57 | 208.4 | 38.2 |
| Example 11 | 135/130 | 0.15 | 89 | 220.9 | 19.0 |
| Example 12 | 135 | 0.15 | 89 | 233.3 | 21.8 |
| Comparative Example 1 | 90 | 0.15 | 89 | 182.1 | 107.7 |
| Comparative Example 2 | 135 | 6.5 | 51 | 234.3 | 184.7 |
| Comparative Example 3 | 135 | 5.2 | 59 | 221.8 | 165.5 |
| Comparative Example 4 | 155 | 0.15 | 89 | 215.5 | 63.2 |
| Comparative Example 5 | 125 | 6.5 | 51 | 226.1 | 173.0 |

DESCRIPTION OF REFERENCE SIGNS

1    polishing pad

2    grid-like groove

10    polishing layer

11    polishing layer

12    side surface

13    groove bottom

14    groove

20    cushion layer

**Claims**

1. A polishing pad comprising at least a polishing layer and a cushion layer, wherein a groove is formed on a polishing surface of the polishing pad, at least one of angles formed by the polishing surface and a side surface of the groove which continues to the polishing surface is 105° or more and 150° or less, and the cushion layer has a strain constant of at least $7.3 \times 10^{-6}$ μm/Pa and at most $4.4 \times 10^{-4}$ μm/Pa.

2. The polishing pad according to claim 1, wherein the cushion layer has a strain constant of at most $3.0 \times 10^{-4}$ μm/Pa.

3. The polishing pad according to claim 1, wherein the cushion layer has a strain constant of at most $1.5 \times 10^{-4}$ μm/Pa.

4. The polishing pad according to any one of claims 1 to 3, wherein a pattern of the groove of the polishing surface is grid-shaped.

[Fig. 1]

[Fig. 2]

[Fig. 3]

[Fig. 4]

[Fig. 5]

[Fig. 6]

<table>
<tr><td colspan="2"><strong>INTERNATIONAL SEARCH REPORT</strong></td><td>International application No.<br>PCT/JP2012/052843</td></tr>
</table>

| A. CLASSIFICATION OF SUBJECT MATTER |
|---|
| *B24B37/26*(2012.01)i, *B24B37/22*(2012.01)i, *H01L21/304*(2006.01)i |

According to International Patent Classification (IPC) or to both national classification and IPC

| B. FIELDS SEARCHED |
|---|
| Minimum documentation searched (classification system followed by classification symbols)<br>B24B37/26, B24B37/22, H01L21/304 |

Documentation searched other than minimum documentation to the extent that such documents are included in the fields searched

| Jitsuyo Shinan Koho | 1922-1996 | Jitsuyo Shinan Toroku Koho | 1996-2012 |
|---|---|---|---|
| Kokai Jitsuyo Shinan Koho | 1971-2012 | Toroku Jitsuyo Shinan Koho | 1994-2012 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2005-236200 A  (Toyo Tire and Rubber Co., Ltd.),<br>02 September 2005 (02.09.2005),<br>paragraphs [0012] to [0020], [0077] to [0093]<br>& US 2007/0178812 A1    & WO 2005/081300 A1<br>& CN 1950930 A | 1-4 |
| Y | JP 2000-286218 A  (Nikon Corp.),<br>03 October 2000 (03.10.2000),<br>paragraphs [0017], [0025]; fig. 1, 5<br>& US 6749714 B1         & WO 2000/059680 A1<br>& TW 0530348 B          & CN 1345264 A | 1-4 |
| Y | JP 2001-1255 A  (Seiko Epson Corp.),<br>09 January 2001 (09.01.2001),<br>paragraphs [0035] to [0036]; fig. 3, 15<br>(Family: none) | 1-4 |

☒ Further documents are listed in the continuation of Box C.　　☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>21 February, 2012 (21.02.12) | Date of mailing of the international search report<br>06 March, 2012 (06.03.12) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2012/052843 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2010-45306 A  (Kuraray Co., Ltd.),<br>25 February 2010 (25.02.2010),<br>entire text; all drawings<br>(Family: none) | 1-4 |
| A | JP 2003-163192 A  (Shin-Etsu Handotai Co., Ltd.),<br>06 June 2003 (06.06.2003),<br>entire text; all drawings<br>(Family: none) | 1-4 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002144219 A
- JP 2004186392 A
- JP 2010045306 A